# EUROPÄISCHE PATENTSCHRIFT

(11) **EP 2 841 628 B1**
(45) Veröffentlichungstag und Bekanntmachung des Hinweises auf die Patenterteilung: **06.06.2018**
(21) Anmeldenummer: 13716310.1
(22) Anmeldetag: 16.04.2013
(51) Int. Cl.: C25D 17/00, C25D 17/06, H05K 3/24

(54) **VERFAHREN UND VORRICHTUNG ZUM ELEKTROLYTISCHEN ABSCHEIDEN EINES ABSCHEIDEMETALLS AUF EINEM WERKSTÜCK**
PROCESS AND APPARATUS FOR THE ELECTROLYTIC DEPOSITION OF A METAL LAYER ON A SUBSTRATE
PROCÉDÉ ET DISPOSITIF DE DÉPÔT ÉLECTROLYTIQUE DE MÉTAL SUR UNE PIÈCE

(30) Priorität: 25.04.2012 DE 102012206800
(43) Veröffentlichungstag der Anmeldung: 04.03.2015
(73) Patentinhaber: Atotech Deutschland GmbH, 10553 Berlin (DE)
(72) Erfinder: SCHMITT, Bernd, 90478 Nürnberg (DE); BÖSE, Bernd, 90427 Nürnberg (DE); MÜCKLICH, Frank, 66773 Schwalbach (DE); BRITZ, Dominik, 66740 Saarlouis (DE); SELZNER, Christian, 66123 Saarbrücken (DE)
(86) Internationale Anmeldenummer: PCT/EP2013/057946
(87) Internationale Veröffentlichungsnummer: WO 2013/160160

(56) Entgegenhaltungen:
- WO-A1-2011/054037
- DE-A1- 3 624 481
- DE-A1-102005 034 419
- DE-A1-102007 030 821
- DE-A1-102007 055 338

## Beschreibung

Die vorliegende Erfindung betrifft ein Verfahren und eine Vorrichtung zum elektrolytischen Abscheiden einer elektrisch leitfähigen Schicht, insbesondere eines Metalls auf einem Werkstück. Das Verfahren und die Vorrichtung sollen bei der Herstellung von flächigen, zum Beispiel plattenförmigen Werkstücken oder Endlosfolien, beispielsweise von Leiterplatten und Leiterfolien, Wafern, Solarpanels, Flachbildschirmpanels und dergleichen, als auch bei der Metallisierung von Werkstücken mit anderen Formen, die beispielsweise im Sanitärbereich, in der Automobilindustrie, im Maschinenbau, oder in anderen Gebieten verwendet werden, eingesetzt werden.

Anlagen für die elektrolytische Metallbeschichtung sind üblicherweise Tauchbadanlagen oder Durchlaufanlagen. Eine derartige Vorrichtung ist beispielsweise in DE 36 24 481 A1 beschrieben. Die Anordnung weist eine Elektrolysekammer auf, in der Leiterplatten elektrolytisch mit Metall beschichtet werden. Zum Transport der Leiterplatten durch die Kammer und zur Stromzuführung zu den Leiterplatten dienen Klammern, die die Leiterplatten in ihrer Transportstellung umklemmend greifen. Diese Klammern sind in einer endlos umlaufenden, angetriebenen Reihe vorgesehen. Die Leiterplatten werden in einem Transportbereich gegriffen und elektrisch kontaktiert, sodass sie elektrolytisch metallisiert werden können. Außerhalb des Metallisierungsbereiches ist eine mit der Elektrolyseflüssigkeit gefüllte Entmetallisierungskammer für die Klammern vorgesehen, in der die Klammern von dem bei der Metallisierung aufgebrachten Metall elektrolytisch befreit werden.

In EP 1 115 915 B1 ist eine weitere elektrochemische Behandlungsanlage für Leiterplatten in Form einer Durchlaufhorizontalanlage offenbart. Für die Stromzuführung zu den Leiterplatten dient ein Kontaktierungsorgan mit mindestens einem Kontaktelement, das eine Kontaktfläche aufweist. Die Kontaktflächen können durch Höcker gebildet sein, die zur besseren thermischen Leitfähigkeit aus Kupfer bestehen. Da sich die Kontaktelemente gemäß EP 1 115 915 B1 beim Entmetallisieren, das dem elektrolytischen Behandeln nachfolgt, auflösen würden, wenn sie aus Kupfer bestehen würden, können sie mit einer widerstandsfähigen Beschichtung überzogen werden, beispielsweise aus Gold. Es wird angegeben, dass besonders dünne Basiskupferschichten auf Leiterplatten an den Kontaktierungsstellen oder in angrenzenden Bereichen bei Anwendung großer Ströme, beispielsweise von 40 bis 160 A, über ein Kontaktierungsorgan, "verbrennen", sodass sich dort schwarze Stellen bilden, an denen Kupfer beschädigt oder teilweise sogar vollständig zerstört ist. Zur Behebung dieses Problems wird in diesem Dokument vorgesehen, dass die Gestalt der Kontaktfläche des Kontaktelements gemäß einer bestimmten Bedingung gebildet ist.
Es hat sich allerdings gezeigt, dass die in EP 1 115 915 B1 vorgeschlagenen Maßnahmen nur beschränkt ausreichen, um Probleme bei der elektrischen Kontaktierung der Werkstücke in einer elektrolytischen Metallisierungsanlage zu lösen. Es besteht vor allem die Notwendigkeit, die elektrolytische Metallabscheidung mit einer sehr hohen Abscheiderate, d.h. mit einem großen Strom, zu betreiben, da dadurch die Kosten für das Metallisierungsverfahren gesenkt werden können. Bei Anwendung eines sehr großen Stromes bei der Metallisierung ist neben den in dem genannten Dokument beschriebenen Problemen außerdem beobachtet worden, dass bei der Übertragung des Stromes auf die Werkstücke auch die elektrischen Kontaktelemente der Stromzuführungen beschädigt werden können. Diese Beschädigungen bestehen darin, dass die Kontaktflächen, über die die Kontaktelemente der Stromzuführungen auf die Werkstücke aufgedrückt werden, nach und nach erodieren und dann für die Stromübertragung ungeeignet werden.
Von daher liegt der vorliegenden Erfindung die Aufgabe zugrunde, Maßnahmen zur Abhilfe dieser Probleme zu finden und insbesondere ein Verfahren und eine Vorrichtung zu schaffen, die geeignet sind, eine elektrolytische Metallabscheidung mit großem Strom zu ermöglichen. Daher sollen das Verfahren und die Vorrichtung dazu geeignet sein, einen sehr großen Strom auf die Werkstücke zu übertragen, ohne dass die Kontaktflächen der elektrischen Kontaktelemente oder die Kontaktierungsbereiche und angrenzende Bereiche auf den Werkstückoberflächen, beschädigt oder zerstört werden.
Diese Aufgabe wird durch das Verfahren zum elektrolytischen Abscheiden eines Abscheidemetalls auf einem Werkstück nach Anspruch 1 und die Vorrichtung zum elektrolytischen Abscheiden des Abscheidemetalls auf dem Werkstück nach Anspruch 6 gelöst. Bevorzugte Ausführungsformen der Erfindung sind in den Unteransprüchen angegeben.

Soweit nachfolgend in der Beschreibung und in den Ansprüchen Begriffe, wie Werkstück, Stromzuführungseinrichtung, Kontaktelement, Kontaktfläche, Halteeinrichtung, Anode, Einrichtung zur elektrischen Stromerzeugung, Strippvorrichtung, Kontaktbeschichtungsvorrichtung und Kontaktklammer im Singular verwendet werden, so ist jeweils gleichermaßen der entsprechende Begriff im Plural gemeint und umgekehrt, sofern nicht ausdrücklich etwas anderes angegeben ist.
Das erfindungsgemäße Verfahren zum elektrolytischen Abscheiden eines Abscheidemetalls auf einem Werkstück umfasst die folgenden Verfahrensschritte:
(a) Bereitstellen einer Metallabscheidungsvorrichtung, in der das Werkstück, mindestens eine Anode und ein Metallabscheideelektrolyt angeordnet sind und die eine Einrichtung zur elektrischen Stromerzeugung sowie mindestens eine Stromzuführungseinrichtung in Form jeweils einer Kontaktklammer aufweist, wobei die Kontaktklammer jeweils mindestens ein elektrisches Kontaktelement zur elektrischen Kontaktierung des Werkstückes aufweist (das elektrische Kontaktelement ist der zur elektrischen Kontaktierung des Werkstückes dienende Teil der Stromzuführungseinrichtung, der mindestens eine Kontaktfläche aufweist);
(d) Abscheiden des Abscheidemetalls auf dem mindestens einen elektrischen Kontaktelement, danach;
(b) In-Kontakt-Bringen des mindestens einen elektrischen Kontaktelements mit dem Werkstück; und
(c) Zuführen von elektrischem Strom zum Werkstück über das mindestens eine elektrische Kontaktelement, damit sich das Abscheidemetall auf dem Werkstück abscheidet, und danach
(e) Entfernen von vorhandenem Abscheidemetall von dem mindestens einen elektrischen Kontaktelement;
wobei die Verfahrensschritte (d), (b), (c) und (e) zyklisch wiederholt werden. In erfindungsgemäßer Art und Weise wird vor Verfahrensschritt (b) in einem weiteren Verfahrensschritt (d) das Abscheidemetall auf dem mindestens einen elektrischen Kontaktelement, insbesondere auf der jeweiligen Kontaktfläche des mindestens einen elektrischen Kontaktelements, abgeschieden.
Das in Verfahrensschritt (d) abgeschiedene Abscheidemetall überzieht die Kontaktfläche des elektrischen Kontaktelementes zu mehr als 50 %, vorzugsweise vollständig. Unschädlich sind eventuell vorhandene Poren in der Abscheidemetallschicht. Dadurch kann die Kontaktfläche des elektrischen Kontaktelements zum größten Teil oder vollständig über diese abgeschiedene Abscheidemetallschicht mit der Werkstückoberfläche in Kontakt treten.

Wenn zwischen der Erzeugung der Abscheidemetallschicht auf der Kontaktfläche gemäß Verfahrensschritt (d) und dem In-Kontakt-Bringen der Kontaktfläche mit dem Werkstück gemäß Verfahrensschritt (b) eine vorgegebene Zeitspanne liegt, in der das elektrische Kontaktelement nicht kathodisch polarisiert, d.h. stromlos, ist, kann sich ein Teil der abgeschiedenen Abscheidemetallschicht im Abscheideelektrolyt wieder auflösen. In diesem Falle soll eine ausreichend dicke Abscheidemetallschicht auf der Kontaktfläche erzeugt werden, sodass auch nach Ablauf dieser Zeitspanne noch eine möglichst geschlossene Abscheidemetallschicht vorliegt. Die Schichtdicke des Abscheidemetalls auf der Kontaktfläche vor Kontaktierung des Werkstückes soll mindestens 0,5 µm, bevorzugt mindestens 2 µm, besonders bevorzugt mindestens 5 µm betragen. Aus wirtschaftlichen Gründen soll die gebildete Schicht möglichst nicht dicker als 50 µm sein.
Die erfindungsgemäße Vorrichtung weist auf:
(a) mindestens eine Anode und mindestens eine Stromzuführungseinrichtung in Form jeweils einer Kontaktklammer, wobei die Kontaktklammer jeweils mindestens ein elektrisches Kontaktelement zur elektrischen Kontaktierung des Werkstückes aufweist, wobei die mindestens eine Anode und die mindestens eine Stromzuführungseinrichtung mit einem Metallabscheideelektrolyt in Kontakt bringbar sind, und
(b) eine Einrichtung zur elektrischen Stromerzeugung zur Versorgung der mindestens einen Anode und der mindestens einen Stromzuführungseinrichtung und damit des Werkstückes mit elektrischem Strom.
Erfindungsgemäß weist die Vorrichtung zum elektrolytischen Abscheiden des Abscheidemetalls auf dem Werkstück ferner eine Kontaktbeschichtungsvorrichtung zum Abscheiden des Abscheidemetalls auf den elektrischen Kontaktelementen, insbesondere auf der jeweiligen Kontaktfläche der elektrischen Kontaktelemente, auf. In der Kontaktbeschichtungseinrichtung steht das mindestens eine elektrische Kontaktelement mit dem Werkstück nicht in Kontakt.
Somit besteht eine erfindungswesentliche Maßnahme darin, die elektrischen Kontaktelemente insbesondere im Bereich ihrer Kontaktflächen, über die sie bei der Metallisierung der Werkstücke mit diesen in Kontakt stehen, vor dem In-Kontakt-Bringen mit dem Werkstück mit dem Abscheidemetall zu überziehen. Das bedeutet, dass vorzugsweise das gleiche Metall zum Überziehen der elektrischen Kontaktelemente verwendet wird, das auch für die Metallbeschichtung der Werkstücke dient. Damit wird insbesondere ein besonders guter Stromübergang zwischen Stromzuführungseinrichtung und Werkstück beim Metallisieren der Werkstücke ermöglicht. Durch die erfindungsgemäßen Maßnahmen werden der Kontaktwiderstand sehr klein und entsprechend die lokale Wärmeentwicklung sehr gering.

Es hat sich herausgestellt, dass die vorstehend erläuterten Probleme durch die erfindungsgemäße Maßnahme behoben werden können. Die Kontaktbereiche können sogar mit einem größeren Strom beaufschlagt werden, und das Werkstück kann schneller mit dem Abscheidemetall beschichtet werden.

In Versuchen ist ferner bestätigt worden, dass ein zur Herstellung eines günstigen Stromüberganges erforderlicher inniger mechanischer Kontakt zwischen den elektrischen Kontaktelementen und den Werkstücken, d.h. ein möglichst exaktes flächiges Aufeinanderliegen der Kontaktflächen an der Werkstückoberfläche vorteilhaft ist. Dazu kann die Befestigung des Kontaktelements an der Stromzuführungseinrichtung derart gestaltet sein, dass sie innerhalb eines bestimmten Bereiches flexibel ist, um zum Beispiel ein Abweichen der Kontaktfläche von der parallelen Lage zur Transportebene auszugleichen. Die Elastizität dieser Befestigung ermöglicht eine automatische Ausrichtung der Kontaktfläche parallel zu den Werkstückoberflächen, wobei die Kraft, mit der die Kontaktelemente der Klammer zusammengedrückt werden, ausreichend groß sein muss, um die Kontaktflächen auf die Werkstückoberfläche auszurichten. Vorzugsweise sind die Kontaktflächen der elektrischen Kontaktelemente plan (eben), um einen guten Stromübergang zu erreichen.

Weiterhin kann es vorteilhaft sein, wenn das Basismaterial, zum Beispiel Titan, der Stromzuführungseinrichtung, insbesondere des Kontaktelements, an der Oberfläche, insbesondere der Kontaktfläche, eine gewisse Rauhigkeit besitzt, um eine innige und haftfeste Verbindung zwischen dem Basismaterial und dem abgeschiedenen Metall der Kontaktbeschichtung zu erreichen. Der Rauhigkeitswert Ra kann in einem Bereich von 0,2 bis 10 µm, bevorzugt 0,5 bis 5 µm liegen.

Um einen guten Stromübergang an der Kontaktstelle zu erreichen, hat sich eine Flächenpressung der Kontaktfläche auf dem Werkstück von 0,15 bis 2,5 N/mm², bevorzugt 0,3 bis 1,5 N/mm², als vorteilhaft erwiesen.

Gemäß der vorliegenden Erfindung wird das auf dem mindestens einen elektrischen Kontaktelement vorhandene Abscheidemetall vor Verfahrensschritt (d) in einem weiteren Verfahrensschritt (e) entfernt. Dieses Abscheidemetall kann auf dem elektrischen Kontaktelement bei einer vormaligen Verwendung zum elektrischen Kontaktieren des Werkstückes aufgebracht worden sein. Somit kann dieser Verfahrensschritt (e) auch im Anschluss an Verfahrensschritt (c) bzw. nach Verfahrensschritt (c) und nachdem der Kontakt zwischen der Stromzuführungseinrichtung und dem Werkstück wieder gelöst worden ist durchgeführt werden. Durch diesen zusätzlichen Schritt des Entmetallisierens bei einer wiederholten Verwendung der Stromzuführungseinrichtungen zum elektrischen Kontaktieren der Werkstücke wird vor Verfahrensschritt (d) stets und reproduzierbar ein gleicher Zustand der Kontaktflächen hinsichtlich einer Anhaftung von Abscheidemetall hergestellt. Bevorzugt sind die Kontaktflächen nach dem Entmetallisieren zu weniger als 10 % mit Abscheidemetall bedeckt.
Zur Entfernung des bei der elektrolytischen Metallisierung des Werkstückes auf der mindestens einen Stromzuführungseinrichtung abgeschiedenen Abscheidemetalls weist die erfindungsgemäße Vorrichtung eine elektrolytische Strippvorrichtung auf. Die erfindungsgemäße Vorrichtung zum elektrolytischen Abscheiden eines Abscheidemetalls auf dem Werkstück ist dazu ausgebildet, dass in ihr sowohl die Metallabscheidung auf den Werkstücken gemäß Verfahrensschritt (c), als auch die Entmetallisierung der elektrischen Kontaktelemente gemäß Verfahrensschritt (e) und die Abscheidung von Abscheidemetall auf den elektrischen Kontaktelementen gemäß Verfahrensschritt (d) stattfindet. Somit weist die erfindungsgemäße Vorrichtung einen ersten Bereich auf, in dem die Werkstücke mit Abscheidemetall beschichtet werden, einen zweiten Bereich, in dem die Stromzuführungseinrichtungen von darauf abgeschiedenem Metall wieder befreit werden, und einen dritten Bereich, in dem Abscheidemetall auf den elektrischen Kontaktelementen abgeschieden wird. Der zweite Bereich der erfindungsgemäßen Vorrichtung wird daher von der Strippvorrichtung gebildet und der dritte Bereich von der Kontaktbeschichtungsvorrichtung. Durch diese Bauweise können die Stromzuführungseinrichtungen kontinuierlich zyklisch verwendet werden, da sie nach dem Metallisieren eines Werkstückes, bei dem sie ebenfalls mitmetallisiert werden, in der Strippvorrichtung und der Kontaktbeschichtungsvorrichtung für den nächsten Metallisierungsvorgang vorbereitet werden.

Somit umfasst die erfindungsgemäße Vorrichtung nicht nur die Metallisierungsvorrichtung sondern auch die Strippvorrichtung und die Kontaktbeschichtungsvorrichtung. Grundsätzlich können die beiden letzteren Vorrichtungen aber auch gemeinsam oder jeweils separat in einer anderen Vorrichtung vorgesehen sein als die Metallisierungsvorrichtung. Beispielsweise kann letztere Variante bei Verwendung einer Vertikalanlage eingesetzt werden, in der separate Behälter für die Metallbeschichtung der Werkstücke (Metallisierungsvorrichtung), für die Entmetallisierung der Stromzuführungseinrichtungen (Strippvorrichtung) und für die Beschichtung der Stromzuführungsvorrichtungen mit Abscheidemetall (Kontaktbeschichtungsvorrichtung) vorgesehen sind. Auch können die drei Bereiche voneinander durch Trenneinrichtungen wie Wände oder Abstände, beispielsweise Abstände größer als 100 mm, voneinander derart getrennt werden, sodass gegenseitige Beeinflussungen durch Feldlinien unterdrückt oder vermieden werden.
Gemäß einer weiteren bevorzugten Weiterbildung der vorliegenden Erfindung ist das Abscheidemetall Kupfer. Das elektrische Kontaktelement kann aus Titan hergestellt sein. Titan ist in den üblicherweise zur Kupferabscheidung verwendeten Abscheideelektrolyten beständig. Alternativ können die elektrischen Kontaktelemente auch aus einem anderen Metall, wie zum Beispiel Niob und Edelstahl, bestehen.
Gemäß einer weiteren bevorzugten Weiterbildung der vorliegenden Erfindung wird in Verfahrensschritt (d) zusätzlich zu dem jeweils mindestens einen elektrischen Kontaktelement der mindestens einen Stromzuführungseinrichtung Abscheidemetall auch auf Teilen der mindestens einen Stromzuführungseinrichtung, angrenzend an das jeweilige mindestens eine elektrische Kontaktelement, abgeschieden. Dies gelingt durch eine geeignete geometrische Anordnung der Anoden der Kontaktbeschichtungsvorrichtung in Bezug auf die Stromzuführungseinrichtung, sodass sich auch ausreichend Feldlinien zwischen den an das Kontaktelement angrenzenden Teilen der Stromzuführungseinrichtung und den Anoden ausbilden. Diese zusätzliche Beschichtung von Bereichen der Stromzuführungseinrichtung, die nicht unmittelbar zu der Kontaktfläche gehören, gewährleistet, dass eine Übertragung des Stromes zu der Kontaktfläche mit einem geringeren elektrischen Widerstand und geringerer Wärmeentwicklung erfolgt. Von daher ist anzustreben, dass die auf den elektrischen Kontaktelementen abgeschiedene Schicht des Abscheidemetalls so dick wie möglich ist. Die Schichtdicke des Abscheidemetalls auf den an das Kontaktelement angrenzenden Teilen der Stromzuführungseinrichtung vor der Kontaktierung des Werkstückes soll mindestens 0,5 µm, bevorzugt mindestens 1 µm, besonders bevorzugt mindestens 3 µm, betragen. Eine zu dicke Schicht ist aus wirtschaftlichen Gründen nicht abzuscheiden. Daher sollte die in der Kontaktbeschichtungsvorrichtung gebildete Schicht nicht dicker als 40 µm sein. Die elektrolytische Kontaktmetallabscheidung auf den Kontaktflächen kann mit einer Stromdichte, bezogen auf die zu beschichtenden Flächen der Stromzuführungseinrichtung, von 1 A/dm² bis 35 A/dm² durchgeführt werden.

Gemäß einer weiteren bevorzugten Weiterbildung des erfindungsgemäßen Verfahrens wird das Werkstück in einer Durchlaufanlage zur kontinuierlichen elektrolytischen Metallabscheidung auf einer vorzugsweise horizontalen Transportbahn geführt. In der Durchlaufanlage werden mehrere Stromzuführungseinrichtungen parallel zu der Transportbahn geführt. Dabei stehen zum einen die elektrischen Kontaktelemente der Stromzuführungseinrichtungen gemäß Verfahrensschritt (b) mit dem durch die Vorrichtung durchlaufenden Werkstück in elektrischem Kontakt, und zum anderen wird das Werkstück gemäß Verfahrensschritt (c) über die elektrischen Kontaktelemente polarisiert. Im Anschluss an Verfahrensschritt (c) werden die elektrischen Kontaktelemente zunächst von dem darauf abgeschiedenen Abscheidemetall befreit. Anschließend wird Abscheidemetall gemäß Verfahrensschritt (d) auf den elektrischen Kontaktelementen abgeschieden. Danach werden die elektrischen Kontaktelemente mit einem weiteren Werkstück in Kontakt gebracht. Derartige Durchlaufverfahren sind äußerst effizient, da sie in einer kompakten Anlage durchgeführt werden, einen hohen Durchsatz erlauben und einen automatischen Betrieb ermöglichen.

Somit ist die erfindungsgemäße Vorrichtung zum elektrolytischen Abscheiden eines Abscheidemetalls auf einem Werkstück vorzugsweise eine Durchlaufvorrichtung zur kontinuierlichen elektrolytischen Metallabscheidung mit mehreren Stromzuführungseinrichtungen. Gemäß dieser Ausführungsform der Erfindung sind die Stromzuführungseinrichtungen an einer einen Umlauf bildenden Halteeinrichtung gehalten, wobei die Vorrichtung in einem ersten Bereich des Umlaufes eine Transportbahn für das Werkstück und eine Führung für die Stromzuführungseinrichtungen parallel zu der Transportbahn aufweist, sodass die elektrischen Kontaktelemente mit den Werkstücken in Kontakt gebracht werden und Abscheidemetall auf den Werkstücken abgeschieden wird. Ferner ist die Vorrichtung am Ende des ersten Bereiches dazu ausgebildet, den Kontakt zwischen den Werkstücken und den elektrischen Kontaktelementen wieder zu lösen. Die Strippvorrichtung zur Entfernung von auf den elektrischen Kontaktelementen abgeschiedenem Abscheidemetall bildet einen zweiten Bereich des Umlaufes, und die Kontaktbeschichtungsvorrichtung zum Abscheiden des Abscheidemetalls auf den elektrischen Kontaktelementen bildet einen dritten Bereich des Umlaufes.
Gemäß einer weiteren bevorzugten Weiterbildung der vorstehend erläuterten Ausführungsform können die Stromzuführungseinrichtungen in der Strippvorrichtung und in der Kontaktbeschichtungsvorrichtung in einer Reihe, vorzugsweise in einer endlos umlaufenden Reihe, und hintereinander geführt und vorzugsweise angetrieben werden, wobei sie mit einem Elektrolyt in Kontakt gebracht werden. Vorzugsweise ist die Halteeinrichtung für die Stromzuführungseinrichtungen ein endlos umlaufendes Transportband oder eine endlos umlaufende Transportkette oder dergleichen. Die Stromzuführungseinrichtungen sind vorzugsweise in einer Reihe hintereinander an der Halteeinrichtung befestigt und durchlaufen daher nacheinander die einzelnen Bereiche. Vorzugsweise sind zusätzlich zum ersten, zweiten und dritten Bereich des Umlaufes keine weiteren elektrolytisch wirksamen Bereiche vorgesehen.

Gemäß der vorliegenden Erfindung, wird das Abscheidemetall im zweiten Bereich des Umlaufes elektrolytisch abgelöst, sodass eine schnelle und kontrollierte Entfernung des Abscheidemetalls von den Stromzuführungseinrichtungen erreicht wird. Dieser Vorgang findet in einer Anordnung mit einer Strippelektrode statt, die gegenüber der Stromzuführungseinrichtung kathodisch polarisiert ist. Diese Strippkathode ist der Stromzuführungseinrichtung gegenüberliegend angeordnet und ist auswechselbar befestigt.

Gemäß der vorliegenden Erfindung ist die mindestens eine Stromzuführungseinrichtung eine Kontaktklammer. Mit den Kontaktklammern können die Werkstücke beispielsweise klemmend gegriffen werden, wobei eine vorgegebene Flächenpressung von den elektrischen Kontaktelementen auf die Werkstückoberfläche ausübbar ist. Damit kann ein guter Stromübergang von den elektrischen Kontaktelementen auf die Werkstücke erreicht werden.
Gemäß einer weiteren bevorzugten Weiterbildung der vorliegenden Erfindung kann die mindestens eine Stromzuführungseinrichtung angetrieben sein und damit auch jeweils als Transportelement für die Werkstücke dienen. Hierzu wird vorzugsweise die Halteeinrichtung angetrieben.

Gemäß einer weiteren bevorzugten Weiterbildung der vorliegenden Erfindung weist die Kontaktklammer zwei elektrische Kontaktelemente mit jeweils einer Kontaktfläche, die parallel zueinander angeordnet und einander gegenüber liegend ausgerichtet sind, auf. Über diese beiden elektrischen Kontaktelemente kann beiden Seiten eines insbesondere plattenförmigen Werkstückes Strom zugeführt werden, sodass eine Metallisierung beider Seiten ermöglicht wird. Durch Anordnen der beiden Kontaktelemente beispielsweise an jeweils einem Arm der Stromzuführungseinrichtung, die mittels eines elastischen Elements gegeneinander verspannbar sind, können die beiden Arme und damit die beiden elektrischen Kontaktelemente in eine Schließstellung vorgespannt werden, aus der diese unter Anwendung einer Öffnungskraft in eine Offenstellung überführt werden können. In der Offenstellung sind die beiden elektrischen Kontaktelemente voneinander beabstandet, sodass ein Werkstück zwischen ihnen angeordnet und anschließend klemmend gegriffen werden kann. Werden derartige Klammern in der vorstehend angegebenen Durchlaufanlage verwendet, in der sie an einer einen Umlauf bildenden Halteeinrichtung gehalten sind, können sie in einer Auslaufregion aus dem ersten (Metallisierungs-)Bereich der erfindungsgemäßen Vorrichtung von der Schließstellung in die Offenstellung bewegt werden, sodass die beiden Klammerteile auseinandergedrückt werden. In entsprechender Weise können die geöffneten Klammern in einer Einlaufregion des ersten (Metallisierungs-)Bereiches unter der Einwirkung der elastischen Kraft zusammenfahren und die Werkstücke klemmend greifen. Im zweiten Bereich des Umlaufes (in der Strippvorrichtung) und im dritten Bereich des Umlaufes (in der Kontaktbeschichtungsvorrichtung) bleiben die Klammerkontaktflächen in der zueinander beabstandeten Stellung.

Anstelle von Klammern können auch Stromzuführungseinrichtungen in anderer Form (nicht Teil der Erfindung) eingesetzt werden, beispielsweise Kontakträder. Die Kontakträder laufen mit ihren Stirnflächen auf den Werkstückoberflächen. Es können Kontakträderpaare mit jeweils zwei einander gegenüberliegenden Kontakträdern vorgesehen sein, um beide Seiten eines Werkstückes gleichzeitig kontaktieren zu können. Die Kontakträder können segmentiert sein, um eine Entmetallisierung und Kontaktbeschichtung auf der den Werkstückoberflächen gegenüberliegenden Bereichen der Kontakträder zu erreichen. Hierzu werden die Segmente der Kontakträder in Abhängigkeit von ihrer jeweiligen Drehstellung in geeigneter Weise gegenüber Gegenelektroden polarisiert.
Die Kontaktflächen der elektrischen Kontaktelemente können eine linien- oder streifenförmige Form haben. Bevorzugt sind sie eben und glatt.

Die Strippvorrichtung im zweiten Bereich der erfindungsgemäßen Vorrichtung weist einen Behälter zur Aufnahme von Strippelektrolyt sowie mindestens eine Strippkathode auf. Dort werden die Strippkathode und die Stromzuführungseinrichtungen, die in die Strippvorrichtung überführt werden und gegenüber der Strippkathode anodisch polarisiert sind, mit dem Strippelektrolyt in Kontakt gebracht. Die Strippkathode ist zu den Stromzuführungseinrichtungen, im Falle einer Durchlaufvorrichtung zum Transportweg der Stromzuführungseinrichtungen, gegenüberliegend angeordnet. In einer weiter bevorzugten Ausführungsform der Erfindung sind die Strippkathoden zwischen den geöffneten, also voneinander beabstandeten, Kontaktelementen der Stromzuführungseinrichtungen angeordnet. Die Strippkathoden können also den elektrischen Kontaktelementen gegenüberliegend oder zwischen zwei voneinander beabstandeten elektrischen Kontaktelementen angeordnet sein. In einer bevorzugten Ausführungsform können Strippkathoden in einer von den elektrischen Kontaktelementen in der Strippvorrichtung zuerst angefahrenen Region den elektrischen Kontaktelementen gegenüberliegen und weitere Strippkathoden in einer von den elektrischen Kontaktelementen danach angefahrenen Region in der Strippvorrichtung zwischen den beiden elektrischen Kontaktelementen angeordnet sein. Ferner können in der Strippvorrichtung zusätzlich Mittel zur Anströmung, beispielsweise Düsen, der zu entmetallisierenden Bereiche der Stromzuführungseinrichtungen mit Elektrolyt angeordnet sein, um eine schnelle Entmetallisierung zu erreichen. Die Strippvorrichtung ist dazu ausgebildet, sämtliches Abscheidemetall, das auf den Stromzuführungseinrichtungen, insbesondere den Kontaktflächen, aufgetragen worden ist, zu mehr als 90 %, vorzugsweise vollständig wieder abzutragen.

Die Kontaktbeschichtungsvorrichtung weist einen Behälter zur Aufnahme von Kontaktbeschichtungselektrolyt sowie mindestens eine Kontaktbeschichtungsanode auf. Dort werden die Kontaktbeschichtungsanode und die Stromzuführungseinrichtungen, die in die Kontaktbeschichtungsvorrichtung überführt sind und gegenüber der Kontaktbeschichtungsanode kathodisch polarisiert sind, mit dem Kontaktbeschichtungselektrolyt in Kontakt gebracht. Die Kontaktbeschichtungsanode ist zu den Stromzuführungseinrichtungen, im Falle einer Durchlaufvorrichtung zum Transportweg der Stromzuführungseinrichtungen, gegenüberliegend angeordnet. In einer weiter bevorzugten Ausführungsform der Erfindung sind die Kontaktbeschichtungsanoden zwischen den geöffneten, also voneinander beabstandeten, Kontaktelementen der Stromzuführungseinrichtungen angeordnet. Die Kontaktbeschichtungsanoden können also den elektrischen Kontaktelementen gegenüberliegend oder zwischen zwei voneinander beabstandeten elektrischen Kontaktelementen angeordnet sein. In einer bevorzugten Ausführungsform können Kontaktbeschichtungsanoden in einer von den elektrischen Kontaktelementen in der Kontaktbeschichtungsvorrichtung zuerst angefahrenen Region den elektrischen Kontaktelementen gegenüberliegen und weitere Kontaktbeschichtungsanoden in einer von den elektrischen Kontaktelementen danach angefahrenen Region in der Kontaktbeschichtungsvorrichtung zwischen den beiden elektrischen Kontaktelementen angeordnet sein. Ferner können in der Kontaktbeschichtungsvorrichtung zusätzlich Mittel zur Anströmung, beispielsweise Düsen, der zu metallisierenden Bereiche der Stromzuführungseinrichtungen, insbesondere der Kontaktflächen, mit Elektrolyt angeordnet sein, um eine haftfeste und glatte Metallisierung der elektrischen Kontaktelemente mit dem Abscheidemetall zu erreichen.

Wo eine Metallisierung der in den Elektrolyt eingetauchten Stromzuführungseinrichtungen nicht gewünscht ist, können sie von einer Abschirmschale umgeben oder mit einer isolierenden Schicht beschichtet sein, um Feldlinien abzuschirmen.

Gemäß einer weiteren bevorzugten Weiterbildung der Erfindung haben der Abscheideelektrolyt, der Strippelektrolyt und der Kontaktbeschichtungselektrolyt die gleiche Zusammensetzung. Daher können die Behälter zur Aufnahme der drei Elektrolyte in den drei Bereichen der erfindungsgemäßen Vorrichtung miteinander verbunden sein, sodass der Elektrolyt in den drei Bereichen zwischen den Behältern überführt werden kann, zum Beispiel durch entsprechende Strömungsführung.

Gemäß einer weiteren bevorzugten Weiterbildung der Erfindung ist der zweite Bereich, d.h. die Strippvorrichtung, mindestens halb so lang und höchstens dreimal so lang wie der dritte Bereich, d.h. die Kontaktbeschichtungsvorrichtung. Vorzugsweise ist der zweite Bereich etwa (+/-30 %) doppelt so lang wie der dritte Bereich.

Die Anoden im dritten Bereich des Umlaufes, d.h. in der Kontaktbeschichtungsvorrichtung, können insbesondere aus einem unter den Bedingungen der Elektrolyse in den jeweiligen Elektrolyten beständigen Material bestehen. Beispielsweise kann es sich um ein Ventilmetall, beispielsweise Ti, handeln, das mit Pt oder mit einem Mischoxid beschichtet ist. Derartige unlösliche Anoden können zusammen mit einem Abscheideelektrolyt eingesetzt werden, der ein Redoxpaar bildende Zusätze wie Fe²⁺/Fe³⁺ enthält. Grundsätzlich können auch lösliche Anoden aus dem Abscheidemetall verwendet werden.

Die Metallisierung im Metallisierungsbereich und/oder die Entmetallisierung im Entmetallisierungsbereich und/oder die Kontaktbeschichtung im Kontaktbeschichtungsbereich können jeweils mit Gleichstrom oder pulsförmigem Strom betrieben werden. Im Falle von pulsförmigem Strom kann eine unipolare Pulsfolge, also mit ausschließlich kathodischen Pulsen an den Kontaktelementen im Kontaktbeschichtungsbereich und anodischen Pulsen an den elektrischen Kontaktelementen im Entmetallisierungsbereich, oder eine bipolare Pulsfolge, also mit Wirkpulsen und zwischen diesen mit Pulsen umgekehrter Polarität, gegebenenfalls des Weiteren mit Pulspausen eingesetzt, werden.

Die vorstehend erläuterte Erfindung ist insbesondere für die Abscheidung von Kupfer auf Werkstücken, vorzugsweise aus einem Kupfer(II)-Ionen, Schwefelsäure, Chlorid und übliche Badadditive enthaltenden Abscheideelektrolyt, anwendbar.

Grundsätzlich kann die Erfindung auch für die Abscheidung von Metallen eingesetzt werden, die eine Verbesserung der Kontakteigenschaften bewirken. Beispielsweise dann wenn die Erfindung zur Abscheidung von Nickel oder Chrom dient und das jeweilige Metall vor der Verwendung der Stromzuführungseinrichtungen zur elektrischen Kontaktierung der Werkstücke auf die elektrischen Kontaktelemente abgeschieden wird, können die damit hergestellten Metallüberzüge die Kontaktflächen auch gegen Abrieb und/oder Korrosion schützen und/oder diesen eine große Härte verleihen. Durch Verringerung des Abriebes und der Korrosionsneigung wird ebenfalls eine Verbesserung der Stromübertragung erreicht.

Die vorliegende Erfindung wird Bezug nehmend auf die folgenden Figuren näher beschrieben:
- Fig. 1:: zeigt eine perspektivische Ansicht einer erfindungsgemäßen Durchlaufvorrichtung zur Behandlung von Leiterplatten in einer schematischen Darstellung;
- Fig. 2:: zeigt einen Querschnitt der erfindungsgemäßen Durchlaufvorrichtung zur Behandlung von Leiterplatten von Fig.1 in einer schematischen Darstellung;
- Fig. 3:: zeigt eine Draufsicht auf die erfindungsgemäße Durchlaufvorrichtung zur Behandlung von Leiterplatten von Fig. 1 in einer schematischen Darstellung;
- Fig. 4:: zeigt eine perspektivische Ansicht eines Teils einer Stromzuführungseinrichtung mit elektrischen Kontaktelementen in einer ersten Ausführungsform;
- Fig. 5:: zeigt Ansichten einer Stromzuführungseinrichtung mit zwei gegeneinander verspannbaren Klammerorganen in einer zweiten Ausführungsform;
- Fig. 6: zeigt den Ablauf des erfindungsgemäßen Verfahrens;
- Fig. 7: zeigt in einer schematischen Querschnittdarstellung eine Ausführung mit einem Kontaktierungsrad (nicht Teil der Erfindung)

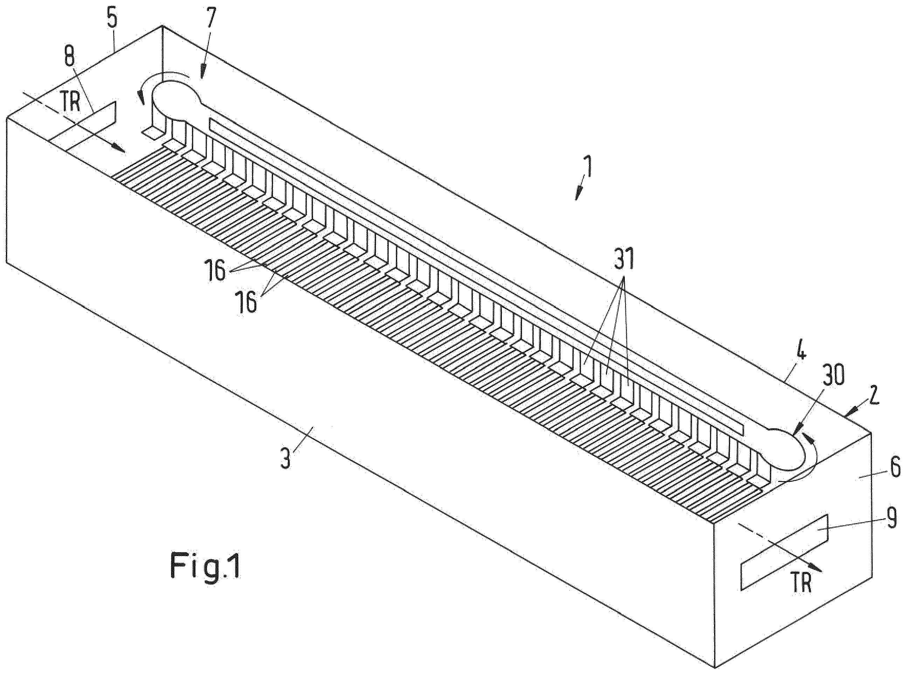

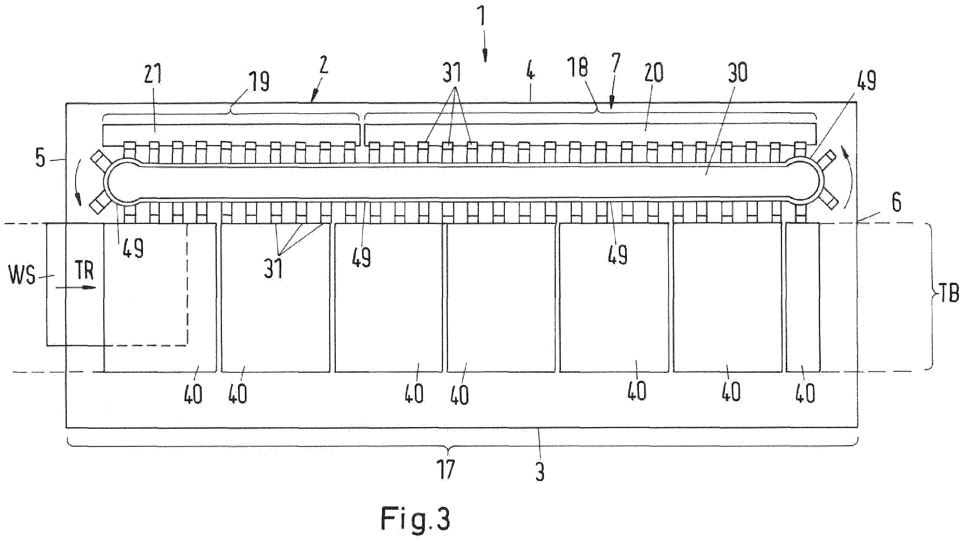

Gleiche Bezugszeichen in den Figuren bezeichnen Elemente mit derselben Funktion.
Die in den Fig. 1, 2 und 3 dargestellte Durchlaufvorrichtung 1 dient zur kontinuierlichen elektrolytischen Metallabscheidung auf Werkstücken WS, hier Leiterplatten. Die Vorrichtung 1 kann beispielsweise zur Abscheidung von Kupfer dienen. In diesem Falle wird ein Kupferabscheideelektrolyt verwendet.
Derartige Anlagen 1 weisen ein Gehäuse 2 mit einer Vorderwand 3, einer Rückwand 4, einer Eintrittswand 5 für die Leiterplatten WS, einer Austrittswand 6 für die Leiterplatten und einem Deckel (nicht dargestellt), die zusammen einen Innenraum 7 definieren, auf.
Das Gehäuse 2 ist vertikal zweigeteilt: In einem unteren Abteil 10 ("Sumpf") befindet sich ein Reservoir für einen Abscheideelektrolyt AE. Ein oberes Abteil 11 wird durch eine Wanne 12 gebildet, in der der Abscheideelektrolyt AE ebenfalls gehalten werden kann. In diesem Bereich befindet sich eine Transportbahn TB für die Leiterplatten WS, die durch die Vorrichtung 1 hindurch befördert werden. Die Transportbahn TB ist horizontal ausgerichtet, sodass die Leiterplatten WS in horizontaler Ausrichtung durch die Vorrichtung 1 befördert werden. Die Leiterplatten WS treten durch einen Eintrittsschlitz 8 in der Eintrittswand 5 in den Innenraum 7 der Vorrichtung 1 ein, durchlaufen die Vorrichtung in ihrer Längsrichtung und treten durch einen Austrittsschlitz 9 in der Austrittswand 6 aus der Vorrichtung 1 wieder aus. Da der Abscheideelektrolyt AE in dieser oberen Wanne 12 oberhalb der Transportbahn TB aufgestaut ist, tauchen die Leiterplatten WS in den Abscheideelektrolyt AE dabei vollständig ein. Damit der Abscheideelektrolyt AE durch diese Schlitze 8, 9 nicht nach außen dringt, sind innerhalb des Gehäuses 2 an den Schlitzen 8, 9 übereinander angeordnete Quetschwalzen angeordnet (nicht dargestellt). Im Betrieb wird der Abscheideelektrolyt AE von dem unteren Abteil 10 mittels Pumpen (nicht dargestellt) in das obere Abteil 11 befördert. Hierzu wird der Abscheideelektrolyt AE über Zuleitungen 14 in Düsenstöcke 15, 16 oberhalb und unterhalb der Transportbahn TB befördert, aus denen er in die Wanne 12 ausströmt. Diese Düsenstöcke 15, 16 sind quer zur Längsrichtung der Transportbahn TB (Transportrichtung TR) angeordnet. Die Düsen 13 der Düsenstöcke 15, 16 sind zur Transportbahn TB hin ausgerichtet, sodass aus ihnen ausströmender Abscheideelektrolyt AE direkt gegen die auf der Transportbahn TB beförderten Leiterplatten WS gerichtet wird. Außerdem sind auch Düsen vorgesehen, die gegen die Klammerkontakte gerichtet sind (nicht dargestellt). Die Düsenstöcke 15, 16 sind in der Transportrichtung TR hintereinander angeordnet, sodass die Leiterplatten WS beim Passieren der Vorrichtung 1 auf der gesamten Länge von beiden Seiten intensiv mit dem Elektrolyt AE beströmt werden. In Fig. 1 sind die unteren Düsenstöcke 16 gezeigt. Abscheideelektrolyt AE aus dem oberen Abteil 11 fließt kontinuierlich aus der Wanne 12 in das untere Abteil 10 wieder ab. Außerdem sind Umwälzpumpen und Filter vorhanden (nicht dargestellt).

Das obere Abteil 11 besitzt erfindungsgemäß drei Bereiche: In einem ersten Bereich 17, der sich zwischen dem Eintrittsschlitz 8 und dem Austrittsschlitz 9 erstreckt, findet die Metallisierung der Leiterplatten WS statt. Dieser erste Bereich wird als Metallisierungsbereich 17 bezeichnet. Er wird definiert durch eine Metallisierungsvorrichtung 17. In einem zweiten Bereich 18, der sich über einen Teil rückwärtig zu einem Kontaktklammerdom 30 erstreckt, werden Kontaktklammern 31 entmetallisiert. Dieser zweite Bereich wird als Entmetallisierungsbereich 18 bezeichnet. Er wird durch eine Strippvorrichtung 18 definiert. In einem dritten Bereich 19, der sich wie der zweite Entmetallisierungsbereich 18 auf der rückwärtigen Seite des Kontaktklammerdoms 30 befindet, erstreckt sich ein Kontaktbeschichtungsbereich 19, der durch eine Kontaktbeschichtungsvorrichtung 19 gebildet wird. In ihm werden die Kontaktklammern 31 wieder mit Abscheidemetall (Kupfer) beschichtet. Der Entmetallisierungsbereich 18 ist vorzugsweise etwa (+/-30%) doppelt so lang wie der Kontaktbeschichtungsbereich 19.

Diese drei Bereiche 17, 18, 19 können im oberen Abteil 11 ein gemeinsames Reservoir zur Aufnahme eines Elektrolyten AE bilden. Dann kann der Elektrolyt AE zwischen allen drei Bereichen 17, 18, 19 strömen.

Oberhalb und unterhalb der Transportbahn TB befinden sich im Metallisierungsbereich 17 Anoden 40, 41.

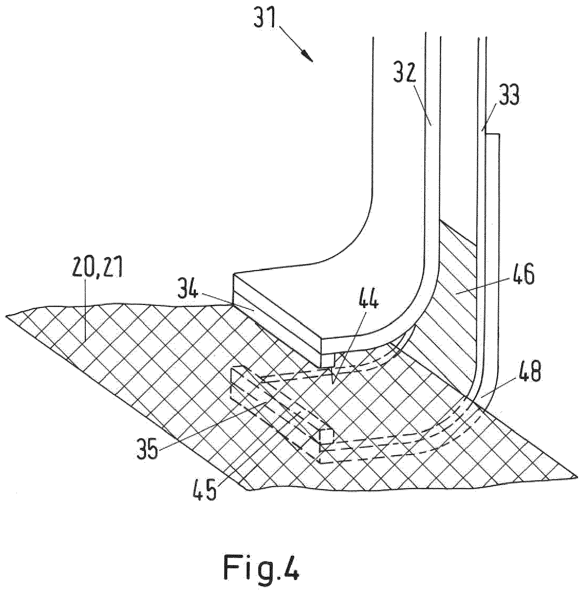

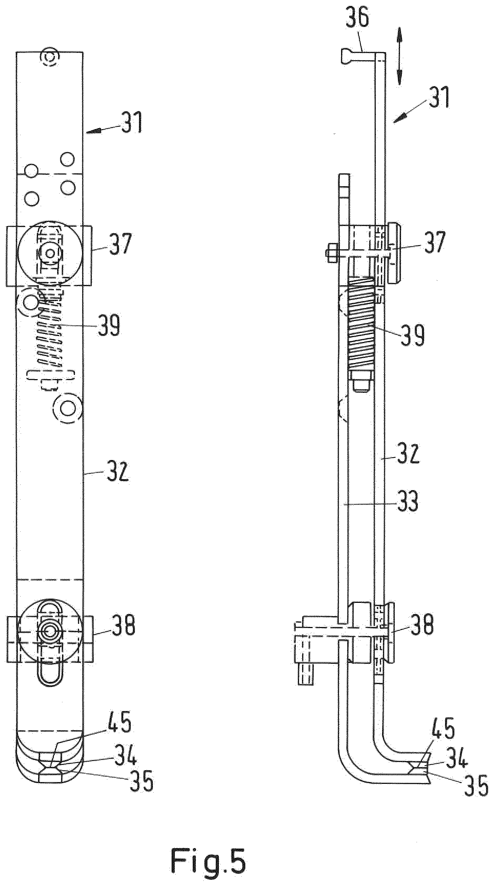

Der das obere Abteil 11 in eine vordere Region (Metallisierungsbereich 17) und eine rückwärtige Region (Entmetallisierungsbereich 18 und Kontaktbeschichtungsbereich 19) unterteilende Dom 30 dient zum Antrieb und zur Führung der Stromzuführungseinrichtungen 31, die der Stromzuführung zu den durch die Vorrichtung 1 hindurch laufenden Leiterplatten WS dienen. Die Stromzuführungseinrichtungen sind durch Klammern 31 gebildet, die jeweils zwei Klammerarme 32, 33 aufweisen, an deren einem Ende sich jeweils ein Kontaktelement 34, 35 mit einer Kontaktfläche befindet (Fig. 4, 5). Mehrere derartige Klammern 31 sind an einer endlosen Halteeinrichtung 49, beispielsweise einem Zahnriemen, in einem gleichen Abstand voneinander befestigt, wobei die Kontaktelemente 34, 35 der Klammern 31 jeweils am unteren Ende der Klammern angebracht sind. Die Halteeinrichtung 49 wird von dem Kontaktklammerdom 30 gehalten und läuft auf diesem um. Der das obere Kontaktelement 34 tragende Klammerkontaktarm 32 ist gegenüber dem Klammerkontaktarm 33 vertikal beweglich. Die Klammern 31 werden in dem Metallisierungsbereich 17 parallel zur Transportbahn TB geführt, wobei die Bahn der Kontaktelemente 34, 35 etwa in der Höhe der Transportbahn TB verläuft.

Die von dem ersten Bereich 17 in den zweiten Bereich 18 und danach in den dritten Bereich 19 gelangenden Klammern 31 verbleiben im zweiten Bereich 18 und im dritten Bereich 19 in der geöffneten Stellung. In diesen Bereichen 18, 19 werden die Klammern 31 befördert, ohne dass sie Leiterplatten WS greifen. Im Metallisierungsbereich 17 werden die Klammern 31 zusammen mit Leiterplatten WS transportiert und sind dann geschlossen. Die Klammern 31 und ihre Halteeinrichtung 49 sind dazu ausgebildet, die Leiterplatten WS durch den Innenraum 7 des Gehäuses 2 zu befördern. Hierzu ist die Halteeinrichtung 49 selbst angetrieben und transportiert damit über die Klammern 31 die Leiterplatten WS. Die Klammern 31 dienen daher nicht nur zur Stromzuführung zu den Leiterplatten WS sondern auch als Transportorgane für diese.

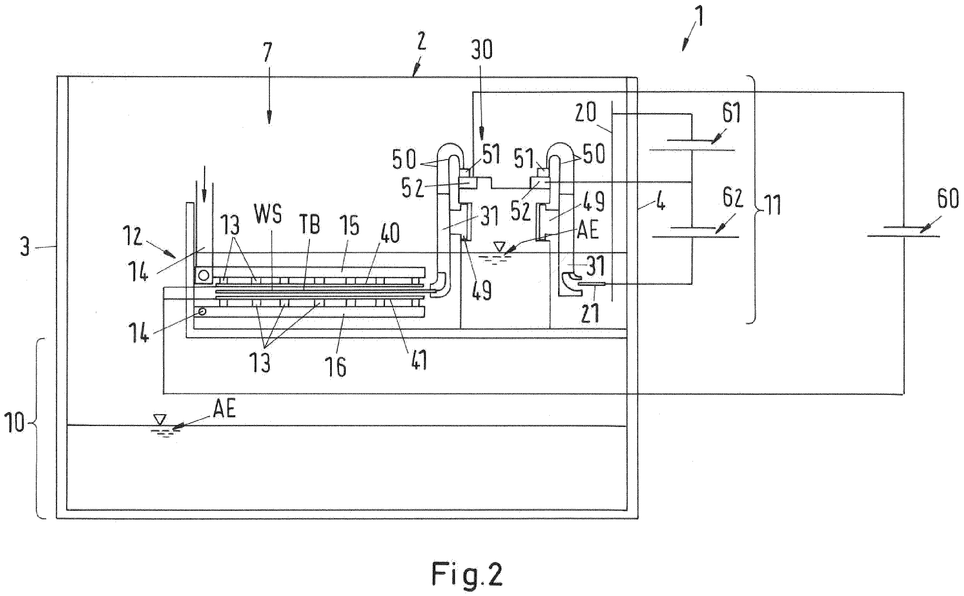

Im zweiten (Entmetallisierungs-)Bereich 18 befindet sich eine Gegenelektrode 20, die über eine angeschlossene Stromquelle 61 kathodisch gegenüber den vorbei laufenden Kontaktklammern 31 polarisiert wird. Diese Strippkathode 20 kann aus verschiedenen Einzelstrippkathoden bestehen. Sie ist innerhalb des Elektrolyten bei geöffneten Kontaktklammern 31 zwischen den Kontaktflächen der elektrischen Kontaktelemente 34, 35 angeordnet (wie in Fig. 4 gezeigt ist). Sie kann auch zu den vorbei laufenden Kontaktklammern 31 gegenüberliegend angeordnet sein (wie in Fig. 2 gezeigt ist). Auch kann sie in Beförderungsrichtung der Kontaktklammern 31 gesehen zuerst gegenüber den vorbei laufenden Kontaktklammern 31 und danach zwischen den Kontaktflächen der elektrischen Kontaktelemente 34, 35 angeordnet sein. Die Einzelstrippkathoden können mit unterschiedlichen Strömen oder Spannungen betrieben werden. Dazu können sie mit Strom/Spannungsquellen verbunden sein, die unterschiedliche Ströme/Spannungen abgeben. Insbesondere kann, in Transportrichtung der Kontaktklammern gesehen, die erste Einzelstrippkathode mit einem höheren Strom bzw. einer höheren Stromdichte betrieben werden als die letzte Einzelstrippkathode.

Im dritten (Kontaktbeschichtungs-)Bereich 19 befindet sich eine Gegenelektrode 21, die über eine angeschlossene Stromquelle 62 anodisch gegenüber den vorbei laufenden Kontaktklammern 31 polarisiert wird. Diese Kontaktbeschichtungsanode 21 kann aus verschiedenen Einzelkontaktbeschichtungsanoden bestehen. Sie ist innerhalb des Elektrolyten bei geöffneten Kontaktklammern 31 zwischen den Kontaktflächen der elektrischen Kontaktelemente 34, 35 angeordnet (wie in Fig. 2, 4 gezeigt ist). Sie kann auch zu den vorbei laufenden Kontaktklammern 31 gegenüberliegend angeordnet sein. Dann soll der Abstand zu den Kontaktelementen 34, 35 kleiner als 30 mm sein. Auch kann sie, in Beförderungsrichtung der Kontaktklammern 31 gesehen, zuerst gegenüber den vorbei laufenden Kontaktklammern 31 und danach zwischen den Kontaktflächen der elektrischen Kontaktelemente 34, 35 oder umgekehrt angeordnet sein. Die Einzelkontaktbeschichtungsanoden können mit unterschiedlichen Strömen oder Spannungen betrieben werden. Dazu können sie mit Strom/Spannungsquellen verbunden sein, die unterschiedliche Ströme/Spannungen abgeben. Insbesondere kann, in Transportrichtung der Kontaktklammer gesehen, die erste Einzelkontaktbeschichtungsanode mit einem höheren Strom bzw. einer höheren Stromdichte betrieben werden als die letzte Einzelstrippkathode.
Im Metallisierungsbereich 17 werden die Kontaktklammern 31 über eine Stromquelle 60 mit Strom versorgt. Die elektrischen Kontaktelemente 34, 35, die sich am unteren Ende der beiden Klammerkontaktarme 32, 33 befinden, dienen zur Stromübertragung auf die Leiterplatten WS, indem sie auf deren untere und obere Oberflächen aufgedrückt werden und anschließend über sie ein elektrischer Strom auf das Werkstück übertragen wird. Wo eine Metallisierung der in den Elektrolyt eingetauchten Kontaktarme 32, 33 nicht gewünscht ist, können sie von einer Abschirmschale 48, beispielsweise aus Kunststoff, umgeben oder mit einer isolierenden Schicht beschichtet sein, um Feldlinien abzuschirmen (Abschirmschale 48, Fig. 4). In der Kontaktbeschichtungsvorrichtung 19 kann ein Teil der Kontaktarme in der Umgebung der Kontaktelemente bei der Metallisierung mitmetallisiert werden. Dieser Beschichtungsbereich 46 ist in Fig. 4 beispielhaft dargestellt.

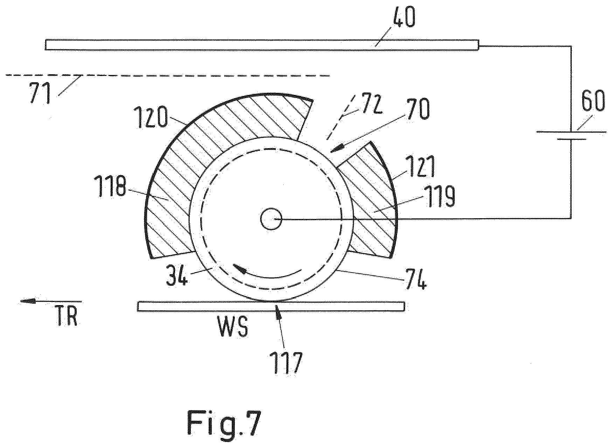

Fig. 7 zeigt als eine alternative Ausgestaltung (nicht Teil der Erfindung) einer Stromzuführungseinrichtung zur elektrischen Kontaktierung des Werkstückes WS ein Kontaktierungsrad 70, welches an die Metallisierungsstromquelle 60 angeschlossen ist. Hierbei erfolgt die elektrische Kontaktierung des Werkstückes WS, vorzugsweise von Flachmaterial, wie zum Beispiel Leiterplatten, über die zylinderförmige Mantelfläche des Kontaktierungsrades 70. Die Abrollbahn auf dem Werkstück WS kann dann streifenförmig oder im Extremfall linienförmig sein. Das Material der Zylinderfläche besteht aus einem leitfähigen Material, vorzugsweise aus Titan oder Edelstahl, oder aus einem leitfähigen Elastomer. Die Kontaktfläche kann umlaufend geschlossen sein, sodass auf allen Flächenbereichen der Zylinderfläche die gleiche Polarität herrscht, oder die Zylinderfläche besteht aus mehreren Einzelkontaktflächen, deren Polarität einstellbar ist. Für die Metallisierung des Werkstückes WS stehen dem Werkstück WS Anoden 40 gegenüber. Vorzugsweise wird Kupfer abgeschieden. Auch bei Verwendung eines Kontaktierungsrades 70 weist die Vorrichtung die drei funktionalen Bereiche als Metallisierungsbereich 117, Entmetallisierungsbereich 118 und Kontaktbeschichtungsbereich 119 auf. Der Metallisierungsbereich 117 befindet sich auf dem Kontaktierungsrad dort, wo dieses mit seiner Kontaktfläche 74 das Werkstück WS berührt. In Rotationsrichtung des Kontaktierungsrades 70 schließt sich daran der Entmetallisierungsbereich 118 an. Dieser weist eine der Kontaktfläche 74 gegenüberliegende Strippkathode 120 auf, welche gegenüber der Kontaktfläche 74 negativ polarisiert ist, sodass an der Kontaktfläche 74 anhaftendes Metall aufgelöst wird. Die Strippkathode 120 kann gegenüber der Anode 40 durch eine isolierende Abschirmung 71 elektrisch abgeschirmt sein, um eine Metallisierung der Strippkathode 120 durch das elektrische Feld zwischen ihr und der Anode 40 zu verringern. Im Fall von Einzelkontaktflächen kann auch auf die Strippkathode 120 verzichtet werden, da dann die Einzelkontaktflächen gegenüber dem Werkstück WS positiv polarisiert werden können und eine Auflösung des Metalls auf der Kontaktfläche 74 stattfindet. Zwischen den Bereichen der Metallisierung 117 und der Entmetallisierung 118 befindet sich der Bereich der erfindungsgemäßen Kontaktbeschichtung 119. Dieser weist eine der Kontaktfläche 74 gegenüberliegende Kontaktbeschichtungsanode 121 auf, welche gegenüber der Kontaktfläche 74 positiv polarisiert ist. Um einen störenden Einfluss der anderen Elektroden zu unterdrücken, kann die Kontaktbeschichtungsanode 121 gegenüber der Anode 40 durch die isolierende Abschirmung 71 und gegenüber der Strippkathode 120 durch die isolierende Abschirmung 72 elektrisch abgeschirmt werden. Auf die Kontaktbeschichtungsanode 121 kann auch verzichtet werden, wenn die Anode 40 die Aufgabe der Kontaktbeschichtungsanode 121 übernimmt, da sie gegenüber der Kontaktfläche 74 positiv polarisiert ist. Der Bereich der Entmetallisierung 118 kann größer sein als der Bereich der Kontaktbeschichtung 119. Das Kontaktierungsrad 70 kann im Metallisierungsbereich 117 oder im Entmetallisierungsbereich 118 oder im Kontaktbeschichtungsbereich 119, beispielsweise über Düsen, angeströmt werden, zum Beispiel mit dem Metallisierungselektrolyt. Das Kontaktierungsrad 70 kann das flächige Werkstück einseitig oder zweiseitig, also vorder- und rückseitig mit dann mindestens zwei Kontaktierungsrädern 70, kontaktieren.

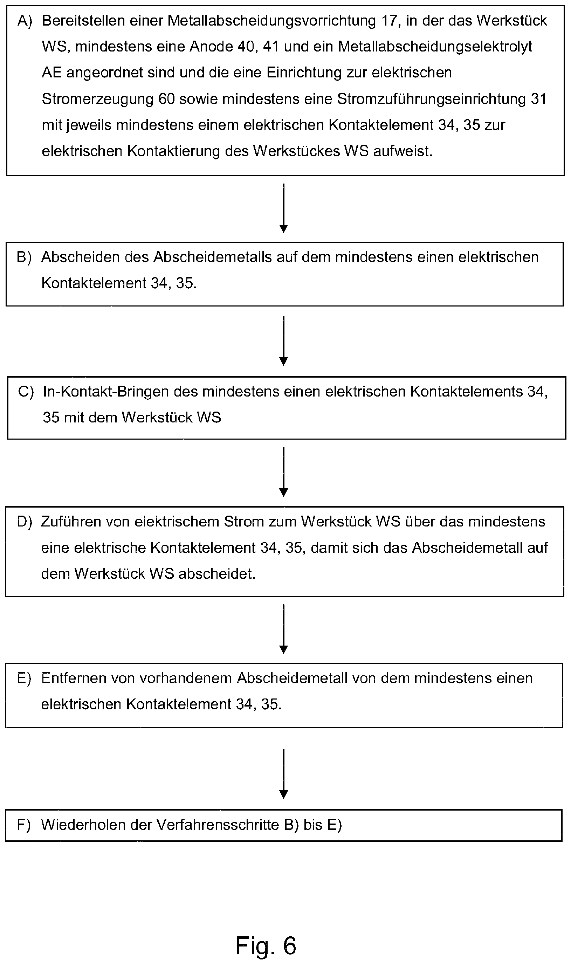

In Fig. 6 ist der Ablauf des erfindungsgemäßen Verfahrens gezeigt:
Zunächst (Schritt A) wird die zuvor beschriebene erfindungsgemäße Vorrichtung 1 mit der Metallabscheidungsvorrichtung 17, in der sich die Leiterplatte WS, die Anoden 40, 41, der Abscheideelektrolyt AE, die Einrichtung zur elektrischen Stromerzeugung 60 sowie Kontaktklammern 31 mit den elektrischen Kontaktelementen 34, 35 befinden, bereit gestellt.

Nachdem die Leiterplatte WS in die Vorrichtung 1 transportiert worden und in eine Region gelangt ist, in der die von der Seite kommenden und gemäß Verfahrensschritt B) mit Kupfer zumindest an den Kontaktflächen der Kontaktelemente 34, 35 beschichteten Kontaktklammern 31 auf ihren Pfad parallel zur Transportbahn TB der Leiterplatte WS einschwenken, greifen die Kontaktelemente 34, 35 die Leiterplatte WS und kontaktieren sie. (Verfahrensschritt C). Beim nachfolgenden Transport durch den Metallisierungsbereich 17 wird die Leiterplatte WS durch die Stromzuführung über die Klammerkontakte 31 gegenüber Anoden 40, 41, kathodisch polarisiert, sodass sich auf der Leiterplatte Kupfer abscheidet, (Verfahrensschritt D). Gleichzeitig kann eine Metallisierung der Kontaktelemente 34, 35 und teilweise auch der angrenzenden Bereiche der Kontaktklammern 31 im Bereich der Klammerkontaktarme 32, 33 stattfinden.

Sobald die Leiterplatte WS die Auslaufregion des Metallisierungsbereiches 17 erreicht hat, geben die Kontaktklammern 31 die Leiterplatte WS nacheinander frei und die Leiterplatte WS wird aus der Vorrichtung 1 heraus befördert. Die Kontaktklammern 31 werden in den zweiten Bereich 18 im rückwärtigen Teil des Doms 30 befördert. Dort werden die Kontaktklammern 31 gegenüber den dort angeordneten Strippkathoden 20 anodisch polarisiert, sodass sich das abgeschiedene Kupfer wieder ablöst (Verfahrensschritt E). Dieser Vorgang kann mit einem Strom von 0,01-2,5 A je Klammer durchgeführt werden. Nach dem Durchlaufen eines Teils der Rücklaufstrecke am rückwärtigen Teil des Doms 30 sind die Kontaktklammern 31 entmetallisiert. Danach laufen sie in den dritten (Kontaktbeschichtungs-)Bereich 19 ein, wo sie gegenüber Kontaktbeschichtungsanoden 21 kathodisch polarisiert werden. Ab diesem Verfahrensschritt wiederholen sich die bisher beschriebenen Verfahrensschritte B bis E (Verfahrensschritt F). Im dritten Bereich wird Kupfer mit einem Strom von 0,2-10 A je Klammer auf den zu metallisierenden Flächen abgeschieden (Verfahrensschritt B). Nachdem eine Kupferschicht mit gewünschter Dicke abgeschieden ist, schwenken die Klammern 31 wieder in den Metallisierungsbereich 17 und nehmen dort weitere unbehandelte Leiterplatten WS auf.

### Bezugszeichenliste:

- 1: Durchlaufanlage,
- 2: Gehäuse
- 3: Vorderwand
- 4: Rückwand
- 5: Eintrittswand
- 6: Austrittswand
- 7: Innenraum
- 8: Eintrittsschlitz
- 9: Austrittsschlitz
- 10: unteres Abteil
- 11: oberes Abteil
- 12: Wanne
- 13: Düsen
- 14: Zuleitungen
- 15, 16: Düsenstock
- 17, 117: erster (Metallisierungs-)Bereich, Metallisierungsvorrichtung
- 18, 118: zweiter (Entmetallisierungs-)Bereich, Strippvorrichtung
- 19, 119: dritter (Kontaktbeschichtungs-)Bereich, Kontaktbeschichtungsvorrichtung
- 20, 120: Gegenelektrode, Strippkathode
- 21, 121: Gegenelektrode, Kontaktbeschichtungsanode
- 30: Kontaktklammerdom
- 31: Kontaktklammern
- 32, 33: Klammerkontaktarm
- 34, 35: Kontaktelement
- 36: abgewinkeltes oberes Ende des Klammerkontaktarmes 32
- 37, 38: Gleitlagerkörper
- 39: Druckfeder
- 40, 41: Anoden
- 44, 45, 74: Kontaktfläche
- 48: Abschirmschale
- 49: Halteeinrichtung, Transportkette, Zahnriemen, Kontaktiereinrichtung
- 50: Kupferlitze
- 51: Schleifkontakt
- 52: Kupferschiene
- 60, 61, 62: Stromquelle
- 70: Kontaktierungsrad
- 71, 72: Abschirmung
- AE: Abscheideelektrolyt
- TB: Transportbahn
- TR: Transportrichtung
- WS: Werkstück, Leiterplatte

## Patentansprüche

1. Verfahren zum elektrolytischen Abscheiden eines Abscheidemetalls auf einem Werkstück (WS), umfassend die folgenden Verfahrensschritte:
(a) Bereitstellen einer elektrolytischen Metallabscheidungsvorrichtung (17), in der das Werkstück (WS), mindestens eine Anode (40, 41) und ein Abscheideelektrolyt (AE) angeordnet sind und die eine Einrichtung zur elektrischen Stromerzeugung (60) sowie mindestens eine Stromzuführungseinrichtung in Form jeweils einer Kontaktklammer (31) aufweist, wobei die Kontaktklammer (31) jeweils mindestens ein elektrisches Kontaktelement (34, 35) zur elektrischen Kontaktierung des Werkstückes (WS) aufweist;
(d) Abscheiden des Abscheidemetalls auf dem mindestens einen elektrischen Kontaktelement (34, 35), danach;
(b) In-Kontakt-Bringen des mindestens einen elektrischen Kontaktelements (34, 35), auf dem sich das in Verfahrensschritt (d) abgeschiedene Abscheidemetall befindet, mit dem Werkstück (WS);
(c) Zuführen von elektrischem Strom zum Werkstück (WS) über das mindestens eine elektrische Kontaktelement (34, 35), damit sich das Abscheidemetall auf dem Werkstück (WS) abscheidet, und danach
(e) Entfernen von vorhandenem Abscheidemetall von dem mindestens einen elektrischen Kontaktelement (34, 35);
wobei die Verfahrensschritte (d), (b), (c) und (e) zyklisch wiederholt werden.

2. Verfahren zum elektrolytischen Abscheiden eines Abscheidemetalls, vorzugsweise von Kupfer, auf einem Werkstück (WS) nach Anspruch 1, **dadurch gekennzeichnet, dass** das in Verfahrensschritt (d) abgeschiedene Abscheidemetall so dick abgeschieden wird, dass vor einem nachfolgenden Verfahrensschritt (c) die Schichtdicke auf der Kontaktfläche mindestens 0,5 µm beträgt.

3. Verfahren zum elektrolytischen Abscheiden eines Abscheidemetalls auf einem Werkstück (WS) nach einem der vorstehenden Ansprüche, **dadurch gekennzeichnet, dass** in Verfahrensschritt (d) zusätzlich zu dem jeweils mindestens einen elektrischen Kontaktelement (34, 35) der mindestens einen Stromzuführungseinrichtung (31) Abscheidemetall auch auf Teilen der mindestens einen Stromzuführungseinrichtung (31), angrenzend an das jeweilige mindestens eine elektrische Kontaktelement (34, 35), abgeschieden wird.

4. Verfahren zum elektrolytischen Abscheiden eines Abscheidemetalls auf einem Werkstück (WS) nach einem der vorstehenden Ansprüche, **dadurch gekennzeichnet, dass** das Werkstück (WS) in einer Durchlaufvorrichtung (1) zur kontinuierlichen elektrolytischen Metallabscheidung auf einer Transportbahn (TB) geführt wird, dass mehrere Stromzuführungseinrichtungen (31) parallel zu der Transportbahn (TB) geführt werden, dabei zum einen die elektrischen Kontaktelemente (34, 35) der Stromzuführungseinrichtungen (31) gemäß Verfahrensschritt (b) mit dem Werkstück (WS) in elektrischem Kontakt stehen und zum anderen das Werkstück (WS) gemäß Verfahrensschritt (c) über die elektrischen Kontaktelemente (34, 35) polarisiert wird, dass die elektrischen Kontaktelemente (34, 35) im Anschluss an Verfahrensschritt (c) zunächst von dem darauf abgeschiedenen Abscheidemetall befreit werden und dass Abscheidemetall auf den elektrischen Kontaktelementen (34, 35) gemäß Verfahrensschritt (d) wieder abgeschieden wird, bevor die elektrischen Kontaktelemente (34, 35) mit einem weiteren Werkstück (WS) in Kontakt gebracht werden.

5. Verfahren zum elektrolytischen Abscheiden eines Abscheidemetalls auf einem Werkstück (WS) nach Anspruch 3, **dadurch gekennzeichnet, dass** die Stromzuführungseinrichtungen (31) an einer einen Umlauf bildenden Halteeinrichtung (49) gehalten werden, dass die elektrischen Kontaktelemente (34, 35) der Stromzuführungseinrichtungen (31) in einem ersten Bereich (17) des Umlaufes mit den Werkstücken (WS) in Kontakt gebracht werden, Abscheidemetall im ersten Bereich (17) auf den Werkstücken (WS) abgeschieden wird und der Kontakt zwischen den Werkstücken (WS) und den elektrischen Kontaktelementen (34, 35) am Ende des ersten Bereiches (17) wieder gelöst wird, dass auf den elektrischen Kontaktelementen (34, 35) abgeschiedenes Abscheidemetall in einem zweiten Bereich (18) des Umlaufes abgelöst wird und dass Abscheidemetall in einem dritten Bereich (19) des Umlaufes auf den elektrischen Kontaktelementen (34, 35) wieder abgeschieden wird.

6. Vorrichtung (1) zum elektrolytischen Abscheiden eines Abscheidemetalls auf einem Werkstück (WS), aufweisend:
(I) in einem ersten Bereich der Vorrichtung (1):
(a) eine elektrolytische Abscheidungsvorrichtung (17), die mindestens eine Anode (40, 41) und mindestens eine Stromzuführungseinrichtung in Form jeweils einer Kontaktklammer (31) aufweist, wobei die Kontaktklammer (31) jeweils mindestens ein elektrisches Kontaktelement (34, 35) zur elektrischen Kontaktierung des Werkstückes (WS) aufweist, wobei die mindestens eine Anode (40, 41) und die mindestens eine Stromzuführungseinrichtung (31) mit einem Abscheideelektrolyt (AE) in Kontakt bringbar sind und das mindestens eine Kontaktelement (34, 35) in der Abscheidungsvorrichtung (17) mit dem Werkstück (WS) in Kontakt gebracht wird; und
(b) eine Einrichtung zur elektrischen Stromerzeugung (60),
(II) in einem zweiten Bereich der Vorrichtung (1):
(a) eine Vorrichtung (18) zur Entfernung des bei der elektrolytischen Metallisierung des Werkstückes (WS) abgeschiedenen Abscheidemetalls von der mindestens einen Stromzuführungseinrichtung (31), die eine Strippkathode (20) aufweist; und
(b) eine Stromquelle (61), die dazu ausgebildet ist, die Strippkathode (20) gegenüber der mindestens einen Stromzuführungseinrichtung kathodisch zu polarisieren;
(III) in einem dritten Bereich der Vorrichtung (1):
(a) eine Kontaktbeschichtungsvorrichtung (19) zum Abscheiden des Abscheidemetalls auf den elektrischen Kontaktelementen (34, 35), in der das mindestens eine elektrische Kontaktelement (34, 35) mit dem Werkstück (WS) nicht in Kontakt steht und die eine Kontaktbeschichtungsanode (21) aufweist; und
(b) eine Stromquelle (62), die dazu ausgebildet ist, die elektrischen Kontaktelemente (34, 35) gegenüber der Kontaktbeschichtungsanode (21) kathodisch zu polarisieren.

7. Vorrichtung (1) zum elektrolytischen Abscheiden eines Abscheidemetalls auf einem Werkstück (WS) nach Anspruch 6, **dadurch gekennzeichnet, dass** die Vorrichtung eine Durchlaufvorrichtung (1) zur kontinuierlichen elektrolytischen Metallabscheidung mit mehreren Stromzuführungseinrichtungen (31) ist, in der die Stromzuführungseinrichtungen (31) an einer einen Umlauf bildenden Halteeinrichtung (49) gehalten sind, wobei die Durchlaufvorrichtung (1) in einem ersten Bereich (17) des Umlaufes eine Transportbahn (TB) für das Werkstück (WS) und eine Führung für die Stromzuführungseinrichtungen (31) parallel zu der Transportbahn (TB) aufweist, sodass die elektrischen Kontaktelemente (34, 35) mit den Werkstücken (WS) in Kontakt bringbar sind und Abscheidemetall auf den Werkstücken (WS) abscheidbar ist, und wobei die Durchlaufvorrichtung (1) am Ende des ersten Bereiches (17) dazu ausgebildet ist, den Kontakt zwischen den Werkstücken (WS) und den elektrischen Kontaktelementen (34, 35) zu lösen, wobei ferner die Vorrichtung (18) zur Entfernung von dem auf den elektrischen Kontaktelementen (34, 35) abgeschiedenen Abscheidemetall einen zweiten Bereich des Umlaufes bildet und wobei die Kontaktbeschichtungsvorrichtung (19) zum Abscheiden des Abscheidemetalls auf den elektrischen Kontaktelementen (34, 35) einen dritten Bereich des Umlaufes bildet.

## Claims

1. Method for electrolytically depositing a deposition metal on a workpiece (WS), comprising the following method steps:
(a) providing an electrolytic metal depositing apparatus (17), in which the workpiece (WS), at least one anode (40, 41) and a deposition electrolyte (AE) are arranged and which has a device for electric current generation (60) and at least one current feeding device each in the form of a contact clamp (31), wherein the contact clamp (31) has in each case at least one electrical contact element (34, 35) for making electrical contact with the workpiece (WS);
(d) depositing the deposition metal on the at least one electrical contact element (34, 35), and then;
(b) bringing the at least one electrical contact element (34, 35) on which the deposition metal deposited in method step (d) is located into contact with the workpiece (WS);
(c) feeding electric current to the workpiece (WS) via the at least one electrical contact element (34, 35) in order that the deposition metal deposits on the workpiece (WS), and then
(e) removing deposition metal present from the at least one electrical contact element (34, 35);
wherein the method steps (d), (b), (c) and (e) are repeated cyclically.

2. Method for electrolytically depositing a deposition metal, preferably copper, on a workpiece (WS) according to Claim 1, **characterized in that** the deposition metal deposited in method step (d) is deposited with a thickness such that, before a subsequent method step (c), the layer thickness on the contact area is at least 0.5 µm.

3. Method for electrolytically depositing a deposition metal on a workpiece (WS) according to either of the preceding claims, **characterized in that**, in method step (d), in addition to the in each case at least one electrical contact element (34, 35) of the at least one current feeding device (31), deposition metal is also deposited on parts of the at least one current feeding device (31), adjacent to the respective at least one electrical contact element (34, 35).

4. Method for electrolytically depositing a deposition metal on a workpiece (WS) according to one of the preceding claims, **characterized in that** the workpiece (WS) is guided in a continuous apparatus (1) for continuous electrolytic metal deposition on a transport path (TB), **in that** a plurality of current feeding devices (31) are guided parallel to the transport path (TB), in this case firstly the electrical contact elements (34, 35) of the current feeding devices (31) are in electrical contact with the workpiece (WS) in accordance with method step (b) and, secondly, the workpiece (WS) is polarized via the electrical contact elements (34, 35) in accordance with method step (c), **in that**, after method step (c), the electrical contact elements (34, 35) are firstly freed of the deposition metal deposited thereon, and **in that** deposition metal is deposited again on the electrical contact elements (34, 35) in accordance with method step (d) before the electrical contact elements (34, 35) are brought into contact with a further workpiece (WS) .

5. Method for electrolytically depositing a deposition metal on a workpiece (WS) according to Claim 3, **characterized in that** the current feeding devices (31) are held on a holding device (49) forming a circulation, **in that** the electrical contact elements (34, 35) of the current feeding devices (31) are brought into contact with the workpieces (WS) in a first region (17) of the circulation, deposition metal is deposited on the workpieces (WS) in the first region (17), and the contact between the workpieces (WS) and the electrical contact elements (34, 35) is released again at the end of the first region (17), **in that** deposition metal deposited on the electrical contact elements (34, 35) is stripped in a second region (18) of the circulation, and **in that** deposition metal is deposited again on the electrical contact elements (34, 35) in a third region (19) of the circulation.

6. Apparatus (1) for electrolytically depositing a deposition metal on a workpiece (WS), comprising:
(I) in a first region of the apparatus (1):
(a) an electrolytic depositing apparatus (17), which has at least one anode (40, 41) and at least one current feeding device each in the form of a contact clamp (31), wherein the contact clamp (31) has in each case at least one electrical contact element (34, 35) for making electrical contact with the workpiece (WS), wherein the at least one anode (40, 41) and the at least one current feeding device (31) can be brought into contact with a deposition electrolyte (AE) and the at least one contact element (34, 35) in the depositing apparatus (17) is brought into contact with the workpiece (WS); and
(b) a device for electric current generation (60),
(II) in a second region of the apparatus (1):
(a) an apparatus (18) for removing the deposition metal deposited during the electrolytic metallization of the workpiece (WS) from the at least one current feeding device (31), which has a stripping cathode (20); and
(b) a current source (61) configured to cathodically polarize the stripping cathode (20) with respect to the at least one current feeding device;
(III) in a third region of the apparatus (1):
(a) a contact coating apparatus (19) for depositing the deposition metal on the electrical contact elements (34, 35), in which apparatus the at least one electrical contact element (34, 35) is not in contact with the workpiece (WS) and which contact coating apparatus has a contact coating anode (21); and
(b) a current source (62) configured to cathodically polarize the electrical contact elements (34, 35) with respect to the contact coating anode (21).

7. Apparatus (1) for electrolytically depositing a deposition metal on a workpiece (WS) according to Claim 6, **characterized in that** the apparatus is a continuous apparatus (1) for continuous electrolytic metal deposition with a plurality of current feeding devices (31), in which the current feeding devices (31) are held on a holding device (49) forming a circulation, wherein the continuous apparatus (1) has, in a first region (17) of the circulation, a transport path (TB) for the workpiece (WS) and a guide for the current feeding devices (31) parallel to the transport path (TB), such that the electrical contact elements (34, 35) can be brought into contact with the workpieces (WS) and deposition metal can be deposited on the workpieces (WS), and wherein the continuous apparatus (1) is designed, at the end of the first region (17), to release the contact between the workpieces (WS) and the electrical contact elements (34, 35), wherein the apparatus (18) for removing the deposition metal deposited on the electrical contact elements (34, 35) furthermore forms a second region of the circulation, and wherein the contact coating apparatus (19) for depositing the deposition metal on the electrical contact elements (34, 35) forms a third region of the circulation.

## Revendications

1. Procédé de dépôt électrolytique d'un métal de dépôt sur une pièce (WS), comprenant les étapes suivantes:
(a) préparer un dispositif de dépôt électrolytique de métal (17), dans lequel la pièce (WS), au moins une anode (40, 41) et un électrolyte de dépôt (AE) sont disposés, et qui présente un dispositif pour la production de courant électrique (60) ainsi qu'au moins un dispositif de fourniture de courant sous la forme chaque fois d'une borne de contact (31), dans lequel la borne de contact (31) présente respectivement au moins un élément de contact électrique (34, 35) pour la mise en contact électrique de la pièce (WS);
(d) déposer le métal de dépôt sur ledit au moins un élément de contact électrique (34, 35), puis:
(b) mettre ledit au moins un élément de contact électrique (34, 35) sur lequel se trouve le métal de dépôt déposé à l'étape (d) en contact avec la pièce (WS);
(c) fournir du courant électrique à la pièce (WS) par l'intermédiaire dudit au moins un élément de contact électrique (34, 35), afin que le métal de dépôt se dépose sur la pièce (WS), et ensuite
(e) enlever du métal de dépôt présent dudit au moins un élément de contact électrique (34, 35),
dans lequel on répète de façon cyclique les étapes (d), (b), (c) et (e).

2. Procédé de dépôt électrolytique d'un métal de dépôt, en particulier de cuivre, sur une pièce (WS) selon la revendication 1, caractérisé en ce l'on dépose le métal de dépôt déposé à l'étape (d) avec une épaisseur telle qu'avant une étape (c) qui suit l'épaisseur de couche sur la face de contact vaille au moins 0,5 µm.

3. Procédé de dépôt électrolytique de métal de dépôt sur une pièce (WS) selon l'une quelconque des revendications précédentes, **caractérisé en ce que** dans l'étape (d), en plus dudit au moins un élément de contact électrique respectif (34, 35) du dispositif de fourniture de courant (31), on dépose du métal de dépôt également sur des parties dudit au moins un dispositif de fourniture de courant (31) adjacentes audit au moins un élément de contact électrique respectif (34, 35).

4. Procédé de dépôt électrolytique de métal de dépôt sur une pièce (WS) selon l'une quelconque des revendications précédentes, **caractérisé en ce que** l'on guide la pièce (WS) dans un dispositif à passage continu (1) pour le dépôt électrolytique continu de métal sur une bande transporteuse (TB), **en ce que** l'on mène plusieurs dispositifs de fourniture de courant (31) parallèlement à la bande transporteuse (TB), en l'occurrence d'une part les éléments de contact électrique (34, 35) des dispositifs de fourniture de courant (31) sont selon l'étape (b) en contact électrique avec la pièce (WS) et d'autre part la pièce (WS) est selon l'étape (c) polarisée au moyen des éléments de contact électrique (34, 35), **en ce qu'**on libère d'abord les éléments de contact électrique (34, 35) à la suite de l'étape (c) du métal de dépôt déposé sur ceux-ci et **en ce que** l'on dépose de nouveau du métal de dépôt sur les éléments de contact électrique (34, 35) selon l'étape (d), avant que les éléments de contact électrique (34, 35) soient mis en contact avec une autre pièce (WS).

5. Procédé de dépôt électrolytique de métal de dépôt sur une pièce (WS) selon la revendication 3, **caractérisé en ce que** l'on maintient les dispositifs de fourniture de courant (31) sur un dispositif de maintien (49) formant une boucle, **en ce que** l'on met les éléments de contact électrique (34, 35) des dispositifs de fourniture de courant (31) en contact avec les pièces (WS) dans une première région (17) de la boucle, on dépose du métal de dépôt sur les pièces (WS) dans la première région (17) et on rompt de nouveau le contact entre les pièces (WS) et les éléments de contact électrique (34, 35) à la fin de la première région (17), en ce l'on enlève du métal de dépôt déposé sur les éléments de contact électrique 34, 35) dans une deuxième région (18) de la boucle et **en ce que** l'on dépose de nouveau du métal de dépôt sur les éléments de contact électrique (34, 35) dans une troisième région (19) de la boucle.

6. Dispositif (1) de dépôt électrolytique de métal de dépôt sur une pièce (WS), présentant:
(I) dans une première région du dispositif (1):
(a) un dispositif de dépôt électrolytique (17), qui présente au moins une anode (40, 41) et au moins un dispositif de fourniture de courant respectivement sous la forme d'une borne de contact (31), dans lequel la borne de contact (31) présente respectivement au moins un élément de contact électrique (34, 35) pour la mise en contact électrique de la pièce (WS), dans lequel ladite au moins une anode (40, 41) et ledit au moins un dispositif de fourniture de courant (31) peuvent être mis en contact avec un électrolyte de dépôt (AE) et ledit au moins un élément de contact (34, 35) est mis en contact avec la pièce (WS) dans le dispositif de dépôt (17); et
(b) un dispositif pour la production de courant électrique (60),
(II) dans une deuxième région du dispositif (1):
(a) un dispositif (18) pour enlever le métal de dépôt déposé lors de la métallisation électrolytique de la pièce (WS) dudit au moins un dispositif de fourniture de courant (31), qui présente une cathode de stripage (20); et
(b) une source de courant (61), qui est configurée de façon à polariser cathodiquement la cathode de stripage (20) par rapport audit au moins un dispositif de fourniture de courant;
(III) dans une troisième région du dispositif, (1):
(a) un dispositif de revêtement de contact (19) pour déposer le métal de dépôt sur les éléments de contact électrique (34, 35), dans lequel ledit au moins un élément de contact électrique (34, 35) n'est pas en contact avec la pièce (WS) et présente une anode de revêtement de contact (21); et
(b) une source de courant (62), qui est configurée de façon à polariser cathodiquement les éléments de contact électrique (34, 35) par rapport à l'anode de revêtement de contact (21).

7. Dispositif (1) de dépôt électrolytique de métal de dépôt sur une pièce (WS) selon la revendication 6, **caractérisé en ce que** le dispositif est un dispositif à passage continu (1) pour le dépôt électrolytique continu de métal avec plusieurs dispositifs de fourniture de courant (31), dans lequel les dispositifs de fourniture de courant (31) sont maintenus sur un dispositif de maintien (49) formant une boucle, dans lequel le dispositif à passage continu (1) présente dans une première région (17) de la boucle une bande transporteuse (TB) pour la pièce (WS) et un guidage pour les dispositifs de fourniture de courant (31) parallèlement à la bande transporteuse (TB), de telle manière que les éléments de contact électrique (34, 35) puissent être mis en contact avec les pièces (WS) et que du métal de dépôt puisse être déposé sur les pièces (WS), et dans lequel le dispositif à passage continu (1) est configuré, à la fin de la première région (17), de façon à rompre le contact entre les pièces (WS) et les éléments de contact électrique (34, 35), dans lequel le dispositif (18) pour enlever le métal de dépôt déposé sur les éléments de contact électrique (34, 35) forme en outre une deuxième région de la boucle, et dans lequel le dispositif de revêtement de contact (19) pour le dépôt du métal de dépôt sur les éléments de contact électrique (34, 35) forme une troisième région de la boucle.
